# DEMANDE DE BREVET EUROPEEN

(11) **EP 0 800 211 A1**
(43) Date de publication de la demande: **08.10.1997**
(21) Numéro de dépôt: 97400710.6
(22) Date de dépôt: 27.03.1997
(51) Int. Cl.: H01L 23/66

(54) **Boîtier de circuit intégré**

(30) Priorité: 03.04.1996 FR 9604192
(71) Demandeur: BULL S.A., 78430 Louveciennes (FR)
(72) Inventeur: Dehaine, Gérard, 92320 Châtillon (FR); Moreau, Michel, 78650 Beynes (FR); Marbot, Roland, 78000 Versailles (FR); Stricot, Yves, 78340 Les Clayes sous Bois (FR)
(74) Mandataire: Denis, Hervé

(57) **Abrégé**

Le boîtier (10) du circuit intégré (11) comprend des conducteurs disposés sur au moins deux niveaux (N1-N6) et répartis de façon que deux paires de conducteurs de deux potentiels fixes (18d, 18g ; 19d, 19g) forment, avec un conducteur (18s) de transmission unipolaire d'un signal, une structure tridimensionnelle approximativement coaxiale ayant une impédance caractéristique sensiblement constante et prédéterminée.

L'invention s'applique aux boîtiers de transmission de signaux à très hautes fréquences.

## Description

### Domaine technique

L'invention a pour objets un procédé de liaison entre un circuit intégré et les bornes extérieures d'un boîtier, un boîtier de circuit intégré et un ensemble électronique en résultant. Elle est plus particulièrement adaptée aux circuits intégrés fonctionnant à très haute vitesse, tels que ceux reliés aux liaisons de transmission de données numériques en série.

### L'art antérieur.

Un boîtier de circuit intégré comprend ordinairement un réseau de conducteurs supporté par un matériau isolant et destiné à relier les bornes d'entrée-sortie d'un circuit intégré aux bornes respectives d'un support de connexion, tel qu'une carte de circuits imprimés. Les bornes du circuit intégré se répartissent en bornes de signal et en bornes d'alimentation en énergie électrique du circuit intégré. La montée continue de la fréquence des signaux traités dans un circuit intégré et du débit de transmission des données entrant et sortant du circuit intégré pose un problème de plus en plus aigu pour la fabrication d'un boîtier de circuit intégré. Dans le boîtier, les conducteurs de liaison et leur support isolant ont des composantes selfiques et capacitives qui ne sont plus négligeables. Ces composantes parasites constituent un obstacle important à l'augmentation de la fréquence des signaux et des débits de transmission.

Il est connu, notamment du brevet EP n° 0 368 740 (US n° 5 254 871) du demandeur, de diminuer les effets parasites des composantes selfiques en incorporant des plans de potentiel dans le boîtier. Ces plans sont disposés de façon à être connectés aux plans respectifs de la carte de circuits imprimés et au plus près des bornes d'alimentation du circuit intégré. Selon un perfectionnement également décrit dans ce brevet, les conducteurs d'alimentation servent de blindage électromagnétique aux conducteurs de signaux. Chaque conducteur d'alimentation est placé entre deux groupes de conducteurs de signaux pour diminuer les interférences entre les signaux des deux groupes.

Cependant, ces moyens s'avèrent encore insuffisants pour satisfaire aux conditions actuellement désirées. Les débits de transmission atteignent plusieurs gigabauds. On sait que la vitesse théorique d'un signal dans un conducteur est égale à la célérité de la lumière divisée par la constante diélectrique du matériau. Un débit d'un gigabaud se traduit donc par la présence, tous les 20 cm environ du conducteur, d'un petit paquet d'électrons représentatif d'un bit de donnée. Cette distance se réduit à environ 5 cm pour un débit de 4 gigabaud. Il est donc important que ces paquets d'électrons ne soient pas perturbés par le passage d'autres paquets circulant sur des conducteurs voisins. Cette perturbation peut se traduire par une diminution du paquet d'électrons ou un étalement du paquet, ainsi que par de petits paquets d'électrons parasites intercalés entre les paquets du signal. Dans ces conditions, le bruit correspondant aux électrons parasites devient important par rapport au signal désiré. L'importance est encore accrue par le fait que des fronts du signal désiré peuvent être atténués comme conséquence d'une diminution des paquets d'électrons correspondants ou de leur étalement. Il devient donc très difficile de reconstituer le signal reçu. En outre, si le signal subit une ou plusieurs réflexions à cause d'interfaces produites par une adaptation d'impédance insuffisante, des électrons vont quitter chaque paquet et constituer des groupes parasites qui rendent impossibles la transmission correcte du signal.

Un autre problème se pose par la coexistence de la transmission de signaux de natures différentes dans un même boîtier. C'est le cas notamment d'un boîtier destiné à un circuit intégré servant à la fois pour le traitement de signaux de données et pour la transmission de données. Dans un système informatique multinodal par exemple, un module de communication internodale de chaque noeud sert à faire un traitement de données en relation avec un processeur, par exemple pour mettre en oeuvre une procédure pour aller chercher des données se trouvant dans un autre noeud, et sert à la transmission internodale de données en série à très haut débit, supérieur au gigahertz. L'incorporation de ce module dans un circuit intégré pose un problème. Par exemple, dans un noeud incorporant un ou plusieurs processeurs du type connu sous le nom de marque PowerPC 620 déposée par la société IBM, le traitement des données est fait dans une première section du circuit intégré adaptée à une commutation de type CMOS. Selon ce type, les amplificateurs tampons utilisés comme interfaces d'entrée-sortie des bornes de signal du circuit intégré sont adaptés pour des fronts de signal de 3,3 volts et peuvent accepter un bruit de l'ordre du volt. Une source importante de bruit est la variation des potentiels d'alimentation dans le temps à cause des composantes selfiques et capacitives des conducteurs d'alimentation. L'importance de ces composantes est diminuée grâce aux plans de tension dans le boîtier. Cependant, la fluctuation des potentiels demeure élevée à cause des fronts relativement élevés de la section (3,3 volts) et des fortes intensités instantanées du courant demandées pour le bon fonctionnement du circuit intégré jusqu'à cinq ampères). Une autre cause de fluctuation est la faible dimension requise des conducteurs d'alimentation dans le circuit intégré, qui présentent donc une résistance non négligeable s'ajoutant aux composantes selfiques et capacitives des conducteurs extérieurs. Le circuit intégré contient aussi une seconde section utilisée pour la transmission de données numériques en série à très haut débit. Dans ce cas, l'amplitude des signaux de transmission est inférieure au volt, de l'ordre de 0,6 à 0,8 volt, c'est-à-dire de l'ordre du bruit toléré dans la première section.

### L'invention

Un but de l'invention est d'abaisser à une valeur négligeable l'interférence entre signaux circulant dans un boîtier de circuit intégré pour des débits supérieurs au gigabaud.

Un autre but est d'assurer une continuité d'impédance jusqu'au plus près du circuit intégré.

Un autre but est d'assurer dans les mêmes conditions une bonne adaptation d'impédance.

Un autre but est de fabriquer un boîtier adapté à toute application, sans affectation prédéterminée des bornes de connexion, chacune pouvant servir pour un signal ou un potentiel d'alimentation, ce qui conduit à un boîtier de type "universel".

Un autre but encore réside dans une mise en oeuvre simple et peu coûteuse de la fabrication d'un boîtier conforme à l'invention.

L'invention a pour objet un procédé de liaison d'un circuit intégré aux bornes extérieures d'un boîtier pour la transmission unipolaire ou différentielle d'au moins un signal, le boîtier comprenant des conducteurs d'au moins deux potentiels fixes, caractérisé en ce que la transmission du signal se fait suivant une structure tridimensionnelle approximativement coaxiale formée de deux paires de conducteurs des deux potentiels et ayant une impédance caractéristique sensiblement constante et prédéterminée.

Elle a pour objet corollaire un boîtier de circuit intégré, comprenant des conducteurs disposés sur au moins deux niveaux et répartis en conducteurs de signaux et en conducteurs d'au moins deux potentiels fixes, caractérisé en ce que deux paires de conducteurs des deux potentiels forment avec un ou deux conducteurs de signal une structure tridimensionnelle approximativement coaxiale ayant une impédance caractéristique sensiblement constante et prédéterminée.

L'invention concerne encore tout ensemble électronique, tel qu'une carte de connexion d'au moins un boîtier conforme à l'invention, où un dispositif, appareil ou système mettant en oeuvre le procédé ou incorporant le boîtier défini ci-dessus.

Les caractéristiques et avantages de l'invention ressortiront de la description qui suit, donnée à titre d'exemple et faite en référence aux dessins annexés.

Dans les dessins :
- la figure 1 est une vue en perspective d'une partie vue en coupe d'un boîtier de circuit intégré conforme à l'invention, monté sur une carte de connexion représentée schématiquement ;
- la figure 2 est, dans sa partie inférieure, une vue de dessus de la partie du circuit intégré représenté sur la figure 1, illustrant une disposition des bornes qui sont connectées au boîtier et, dans sa partie supérieure, une vue en coupe partielle selon une ligne II-II indiquée à la figure 1, illustrant une disposition des conducteurs dans le boîtier représenté sur la figure 1, la figure 2 illustrant aussi un premier exemple de mise en oeuvre du procédé de liaison entre des bornes du circuit intégré et des bornes extérieures d'un boîtier ;
- les figures 3A-3D sont des vues en plan schématique illustrant les conducteurs utilisés sur différents niveaux du boîtier représenté sur la figure 1 ;
- la figure 4 est une vue de détail agrandie de la disposition des trous relatifs au triplet indiqué à la figure 3B et aux quatre triplets voisins inférieurs ;
- la figure 5 est une vue similaire à celle de la figure 4 et illustre une variante de disposition des trous ;
- la figure 6 est une vue similaire à la partie supérieure de la figure 2, illustrant une variante de disposition des conducteurs dans le boîtier représenté sur la figure 1; et
- la figure 7 est une vue similaire à celle de la figure 6 illustrant un second exemple de mise en oeuvre du procédé conforme à l'invention.

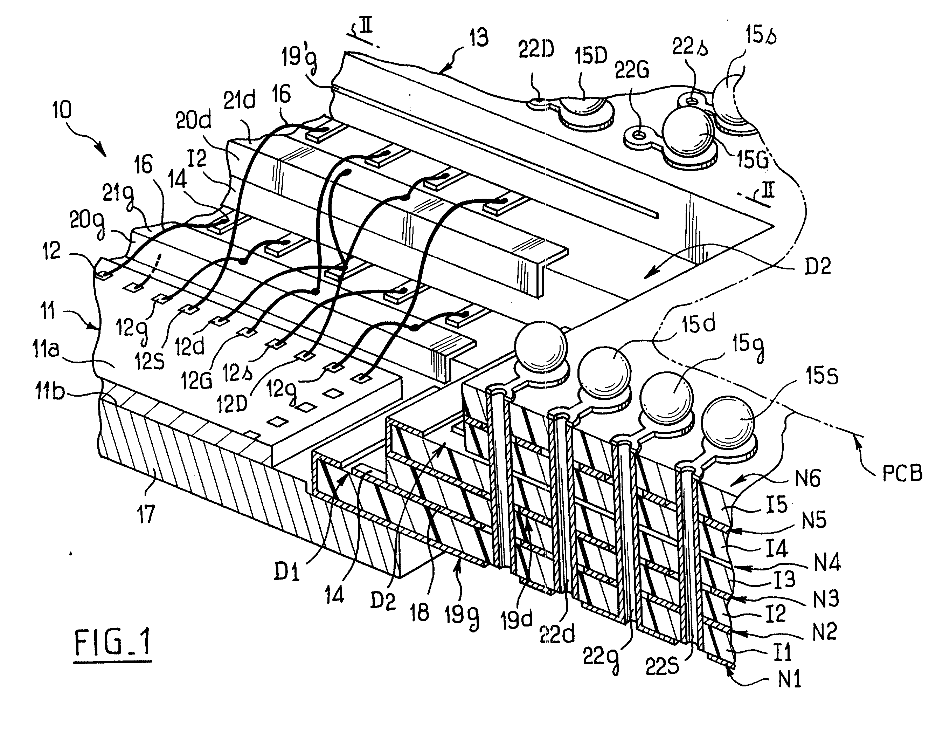

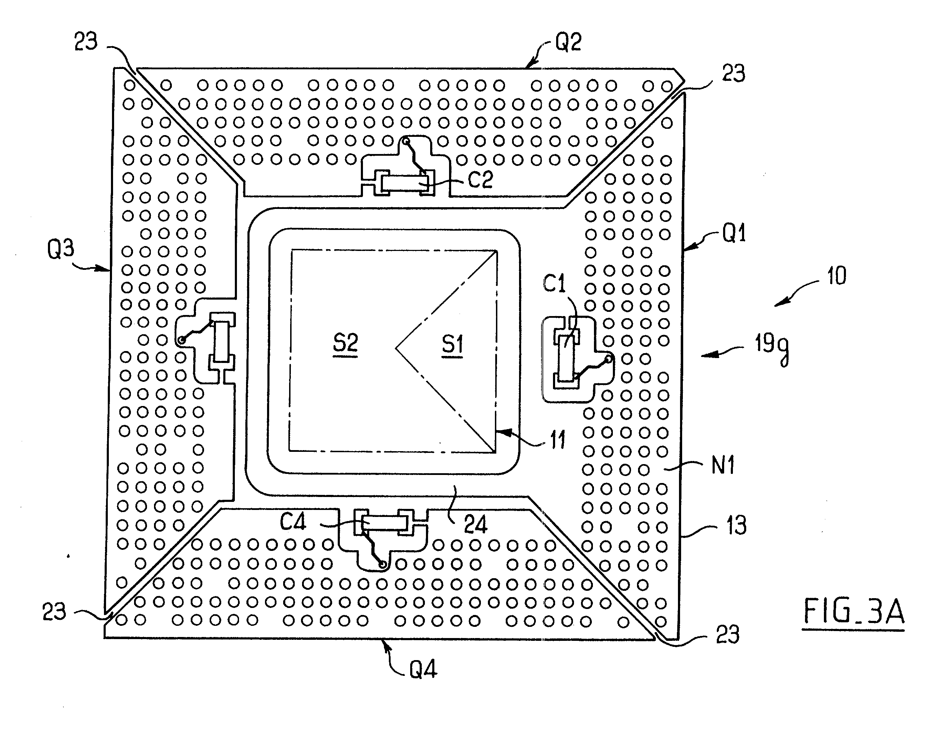

La figure 1 illustre un boîtier 10 conforme à l'invention, prévu pour recevoir au moins un circuit intégré 11. Le circuit intégré 11 a une face active 11a incorporant les composants électroniques et présentant des bornes d'entrée-sortie 12, et une face arrière 11b. On a représenté schématiquement par un trait fantôme sur la figure 3A une vue de la face active 11a du circuit intégré 11. Le circuit intégré 11 pris comme exemple et tel que représenté sur la figure 3A se compose d'une section S1 servant à la transmission de données en série à très haut débit et d'une section S2 servant au traitement de signaux de commutation logique. La limite des deux sections est purement symbolique et signifie dans l'exemple illustré que les bornes d'entrée-sortie 12 relatives à la section S1 se trouvent toutes sur un côté du circuit intégré. On considérera que ce côté est celui connecté au boîtier illustré dans la figure 1. D'autres bornes de ce côté pourraient aussi se rapporter à la section S2. Ce circuit intégré pourrait être un module d'interface d'un sous-système informatique d'entrée-sortie, dont la section S1 servirait à la communication internodale du système informatique et dont la section S2 serait en liaison avec le bus d'un noeud de processeurs pour gérer la communication internodale d'entrée-sortie. Dans ce cas, par exemple, les transitions des signaux de la section S1 ont une amplitude inférieure au volt, alors que celles de la section S2 ont une amplitude relativement plus élevée, ici de 3,3 volts.

Les bornes d'entrée-sortie 12 illustrées dans la figure 1 et connectées au boîtier appartiennent à la section S1 et comprennent des bornes de signal 12s servant à la transmission de données numériques en série et des bornes de potentiel 12d, 12g servant à l'alimentation en énergie électrique du circuit intégré. Les bornes 12g sont représentatives de la masse électrique (Vss en technologie MOS - Métal-Oxyde-Semi-conducteur) tandis que les bornes 12d sont représentatives d'un potentiel fixe prédéterminé (Vdd en technologie MOS). Bien sûr, d'autres potentiels d'alimentation pourraient s'y ajouter. Le circuit intégré illustré comporte aussi des bornes d'entrée-sortie additionnelles de signal 12S et de potentiel 12D et 12G, qui sont intercalées entre les bornes 12s, 12d et 12g. La première partie de la présente description ne tiendra pas compte de ces bornes additionnelles.

Le boîtier 10 comprend essentiellement une structure de connexion 13 pourvue de bornes intérieures 14 et de bornes extérieures 15. Il existe de nombreux types bien connus de structures de connexion pouvant recevoir l'invention. La structure de connexion illustrée est un cadre 13 multicouche et de forme rectangulaire. Les bornes intérieures 14 sont destinées à la connexion aux bornes respectives 12 du circuit intégré. La connexion peut être directe, faite par exemple par soudage ILB (Inner Lead Bonding) de la technologie TAB (Tape-Automated Bonding), ou indirecte comme illustré, faite par des fils de liaison 16 selon la technologie communément appelée "wire bonding". Les bornes extérieures 15 servent à la connexion du boîtier à une carte de connexion, par exemple une carte de circuits imprimés PCB illustrée sous forme très schématique par un trait fantôme.

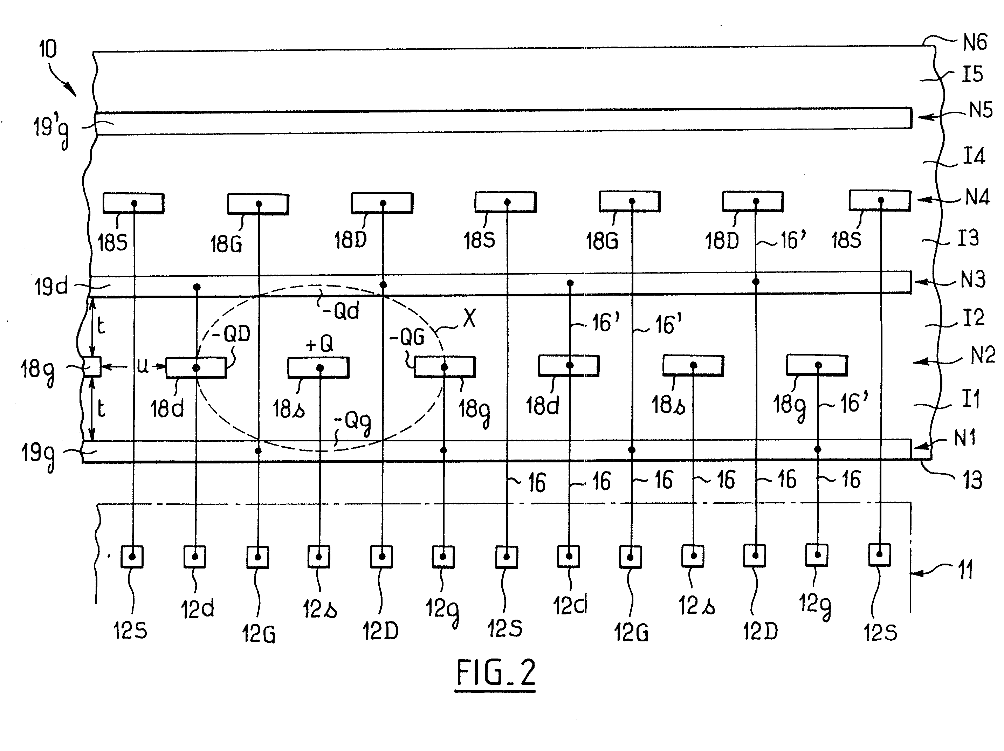

La figure 2 est, dans sa partie basse, une vue partielle de dessus du circuit intégré 11 représenté par un trait mixte, illustrant les bornes d'entrée-sortie 12 qui sont représentées sur la figure 1 parallèlement à la ligne de coupe de cette figure et qui sont en liaison avec le cadre 13. La figure 2 est, dans sa partie haute, une vue partielle et schématique du cadre 13 suivant une ligne de coupe II-II parallèle à celle de la figure 1 et indiquée à cette figure. Le cadre illustré dans les figures 1 et 2 comprend cinq couches isolantes superposées I1 - 15 d'épaisseurs sensiblement égales à une valeur t, faites d'un même matériau, un matériau organique en l'occurrence, et constituant six niveaux de connexion N1-N6. Les niveaux N1 et N6 constituent les faces opposées du cadre 13. Le niveau N1 porte une plaque 17 qui bouche l'ouverture correspondante du cadre 13 pour former une cavité pour le circuit intégré 11. La plaque 17 est destinée à recevoir la face arrière 11b du circuit intégré 11 et lui sert d'interface thermique pour évacuer la chaleur vers un dispositif de refroidissement, tel qu'un radiateur à ailettes (non illustré), couplé à la face extérieure de la plaque 17. Le cadre illustré est un composant CMS (composant monté en surface) ou SMT (Surface Mount Technology) du fait que les bornes extérieures 15 sont disposées sur la surface de niveau N6 du cadre. Il est du type BGA (Ball Grid Array) à cause des bornes extérieures 15 en forme de boules de brasure disposées selon un réseau maillé. Les rapports dimensionnels du boîtier illustré ne correspondent pas à la réalité et ont été distordus de façon à mieux faire ressortir les caractéristiques de l'invention.

Comme toute structure de connexion, le cadre 13 contient des conducteurs connectés aux bornes intérieures 14 et/ou aux bornes extérieures 15. Les conducteurs illustrés dans les figures 1 et 2 sont disposés sur les différents niveaux N1-N6 du cadre. Ils se composent de conducteurs filaires 18 et de conducteurs plans 19 qui s'étendent approximativement sur un niveau du cadre. Les conducteurs plans 19 sont des conducteurs de potentiel d'alimentation en énergie électrique et comprennent deux plans de masse 19g, 19'g disposés sur les niveaux respectifs N1 et N5 et un plan de tension 19d sur le niveau N3. Les conducteurs filaires 18 occupent les niveaux N2 et N4 et les conducteurs du niveau N4 sont dans une position intercalaire avec ceux du niveau N2. Dans l'exemple illustré, la distance u qui sépare les fils conducteurs était de 100 µm et leur largeur de 100 µm également. Comme cela ressort de la figure 2, des conducteurs 18 du niveau N2 sont disposés en correspondance avec les bornes 12s, 12d et 12g du circuit intégré avec le même pas.

De la figure 1, il ressort que les bornes intérieures 14 du cadre 13 sont constituées par des extrémités de fils conducteurs 18 des niveaux N2 et N4. Les bords intérieurs (vers le circuit intégré 11) des couches isolantes I2, I3 sont en recul par rapport au bord intérieur de la couche isolante I1 pour former un premier gradin D1 pour les bornes intérieures 14. De même, les bords intérieurs des couches isolantes I4, I5 sont en recul par rapport aux bords intérieurs des couches isolantes I2, I3 pour former un second gradin D2 présentant les autres bornes intérieures 14. Sur les deux gradins D1 et D2, les bornes intérieures 14 sont placées contre ou près des bords des couches isolantes supérieures respectives I2-I3 et I4-I5 et ont leurs extrémités intérieures (vers le circuit intégré) distantes des bords de la couche isolante sous-jacente respective I1 et I3.

Les plans conducteurs 19g et 19d représentés sur la figure 1 se prolongent par des extensions conductrices au-delà des bords intérieurs des couches isolantes I1 et I3 avec qui elles sont en contact. Les extensions conductrices se composent respectivement des extensions latérales 20g, 20d recouvrant les parois latérales des couches isolantes supérieures respectives I1, I3 et de rebords 21g, 21d recouvrant les parties terminales intérieures des gradins respectifs D1, D2. Sur les gradins D1 et D2, les rebords 21 sont distants des bornes intérieures 14. Dans le boîtier illustré, le plan conducteur 19'g du niveau N5 n'a pas d'extension, puisque la couche isolante supérieure I5 ne présente pas de bornes intérieures 14.

Enfin, les bornes extérieures 15 sont connectées à au moins une partie des conducteurs 18 et 19 de niveaux différents du cadre par l'intermédiaire de trous 22 perpendiculaires aux niveaux du cadre. Les trous illustrés sont des trous métallisés émergeant sur le niveau N6 du cadre 13 pour être connectés aux bornes extérieures respectives 15, ainsi que sur le niveau N1. Cependant, il est clair que d'une manière générale des trous peuvent être borgnes et d'autres peuvent être internes au cadre. Les plans de potentiel 19d et 19g sont connectés aux boules respectives 15d, 15g par l'intermédiaire des trous 22d et 22g. Dans l'exemple illustré, les boules d'alimentation 15d et 15g sont seulement connectées aux plans d'alimentation. En d'autres termes, aucune borne extérieure 15 servant à l'alimentation n'est connectée à un fil 18.

Dans ces conditions, la fonction des fils 18 est déterminée par la connexion des bornes intérieures correspondantes 14, comme indiqué aux figures 1 et 2. La connexion d'une borne intérieure 14 à une borne de signal 12s du circuit intégré par l'intermédiaire d'un fil de liaison 16 détermine un fil de signal 18s, et la connexion d'une borne intérieure 14 à un rebord 21d ou 21g par l'intermédiaire d'un fil de liaison 16' détermine un conducteur de potentiel correspondant 18d ou 18g. Les bornes de potentiel 12d et 12g du circuit intégré sont connectées aux rebords respectifs 21d et 21g par l'intermédiaire de fils de liaison 16. Un fil 16' de liaison à une borne intérieure 14 peut être isolé ou, comme illustré dans la figure 1, être une extension d'un fil 16 de liaison à une borne de potentiel 12d ou 12g. La continuité de chaque rebord fait qu'il peut être facilement connecté sans contrainte à une borne d'alimentation du circuit intégré ou à une borne intérieure 14. Comme autre avantage, chaque liaison d'alimentation 16' est très courte et permet de connecter facilement le fil correspondant 18 à l'un des rebords 21d, 21g.

Les fils de signal 18s sont connectés à des boules respectives 15s par l'intermédiaire de trous 22s, les plans de potentiel 19d et 19g sont connectés aux boules respectives 15d, 15g par l'intermédiaire des trous 22d et 22g et les fils de potentiel 18d, 18g sont connectés à des bornes respectives 15D, 15G par l'intermédiaire des trous 22D, 22G.

La figure 2 illustre une configuration particulièrement adaptée à la transmission à très haut débit de données numériques sur les fils de signaux. Comme illustré par exemple en relation avec les couches isolantes I1 et I2, chaque conducteur de signal 18s est entouré des plans conducteurs de potentiel 19d et 19g et des fils de potentiel 18d et 18g. L'ensemble du fil de signal 18s placé entre ses deux fils de potentiels différents 18d, 18g sera appelé un triplet T. De préférence, l'épaisseur t d'une couche isolante I1-I4 est sensiblement égale à la distance u entre les fils conducteurs, de sorte que les conducteurs de potentiel entourant chaque fil de signal sont symétriques par rapport à lui. Cette disposition des conducteurs de potentiel 18d, 18g, 19g et 19d autour de chaque fil de signal 18s est partiellement assimilable à une gaine d'isolation électromagnétique d'un câble coaxial illustré par un trait tireté X. Comme indiqué à la figure 2, la circulation d'une charge +Q dans un conducteur de signal 18s entraîne par effet électrostatique la circulation de charges -Qd, -Qg dans les conducteurs plans respectifs 19d et 19g et de charges -QD et -QG dans les fils respectifs 18d et 18g, en satisfaisant à la relation Q = Qd + Qg + QD + QG. D'une manière générale, on comprend que la meilleure disposition des conducteurs de la structure coaxiale X formée par les conducteurs 18s, 18d, 18g, 19d et 19g est de répartir en parties égales les charges dans les conducteurs de potentiel, de façon à avoir Qd = Qg = QD = QG = Q/4. Le coefficient diélectrique du ou des matériaux constituant les couches isolantes I1 et I2 étant connu, on peut donc déterminer la valeur de l'épaisseur t et de la distance u de façon à obtenir sensiblement l'impédance caractéristique désirée de la structure coaxiale X. Bien entendu, d'autres contraintes à prendre en compte peuvent avoir pour résultat un écart plus ou moins grand par rapport à cette disposition idéale. Cependant, certaines compensations peuvent être faites pour s'approcher de la condition idéale précitée. Par exemple, si l'épaisseur varie entre deux couches superposées, on peut compenser par une différence du coefficient diélectrique du matériau, et réciproquement.

Deux structures coaxiales voisines pourraient avoir au moins un conducteur commun. Par exemple, les deux triplets voisins illustrés dans la figure 2 pourraient se partager un même conducteur de potentiel, par exemple le conducteur 18g. Dans ce cas cependant, une certaine diaphonie pourrait exister entre les signaux voisins. Pour résoudre ce problème, deux fils de signal 18s voisins sont séparés par deux fils de potentiels différents 18d et 18g. En d'autres termes, chaque fil de signal est entouré de deux fils de potentiels différents non communs aux fils de signal adjacents. Les potentiels différents sur les deux fils 18d et 18g intermédiaires correspondent à une complémentarité des structures voisines.

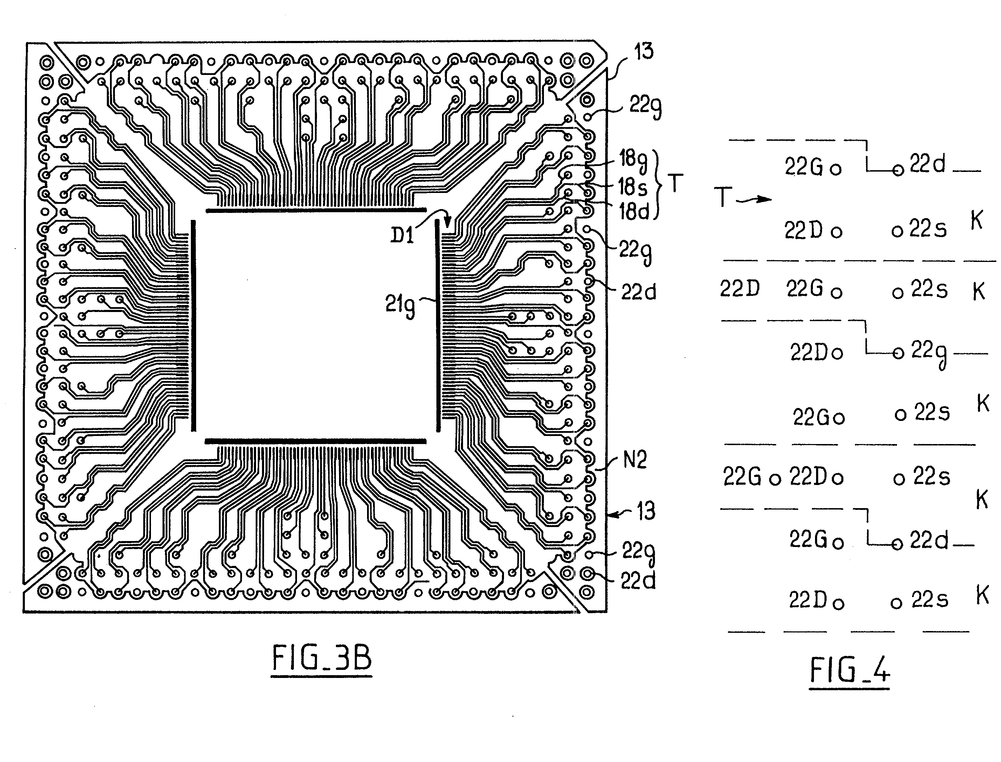

La figure 3B est une vue de dessus du niveau N2 et illustre la disposition en triplets des fils 18. Les triplets T illustrés sont disposés généralement en faisceaux divergeant du gradin D1 jusqu'au voisinage du bord extérieur du niveau N2, à l'exception des deux triplets médians de chaque côté du boîtier. On remarque que dans l'exemple illustré les fils de signal 18s se terminent par des trous respectifs 22s disposés suivant une ligne parallèle et proche du bord extérieur du cadre 13. Sur cette ligne sont aussi disposés les trous 22d et 22g communiquant avec les plans respectifs 19d et 19g. Les fils de masse et tension 18g 18d de chaque triplet se terminent par des trous respectifs 22G, 22D disposés suivant deux autres lignes parallèles et plus en retrait du bord. Les trous périphériques 22 et les bornes extérieures correspondantes 15 sont donc disposés aussi en triplets.

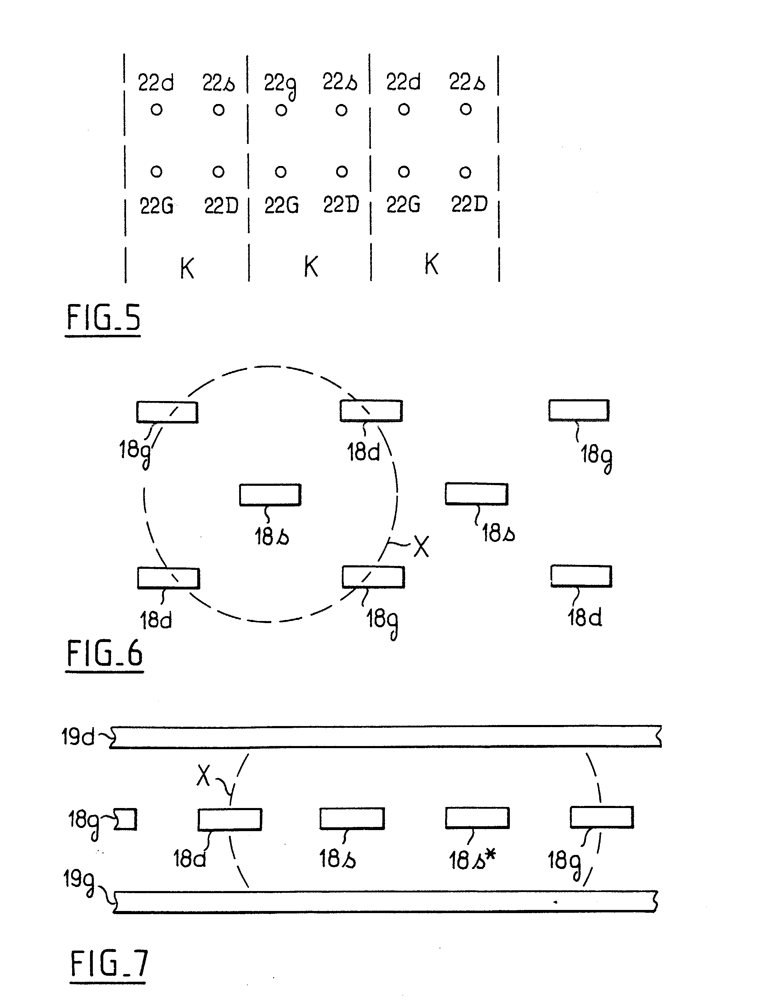

La figure 4 est une vue partielle agrandie de la disposition des trous 22s, 22D et 22G relatifs au triplet T indiqué à la figure 3B et aux quatre triplets voisins inférieurs. A ces triplets s'ajoutent les trous 22d et 22g en liaison avec les plans respectifs 19d et 19g. Les trous 22d et 22g forment avec le trou de signal 22s correspondant un autre triplet. Cependant, pour des raisons de place, les trous 22d et 22g illustrés sont partagés chacun par deux triplets voisins T pour former un quartet K avec chaque triplet T. Les quartets illustrés dans la figure 4 sont délimités par des traits tiretés. Cette disposition des trous 22 assure la continuité de la circulation des charges +Q, -Qd, -Qg, -QD et -QG entre les bornes extérieures correspondantes 15 et le circuit intégré 11. Une rupture de continuité de la circulation des charges au niveau de l'un des trous de potentiel aurait l'inconvénient de perturber la transmission des signaux. Par exemple, si l'un des trous 22d manquait, la charge Qd circulant sur le plan 19d en parallèle avec le signal s sur le fil 18s ne pourrait plus suivre la circulation du signal dans le trou 22s et devrait s'écouler suivant un autre trajet où elle pourrait perturber la transmission du signal et des signaux voisins. Et si un trou 22D en liaison avec le fil 18d manquait, la charge QD arrivant au bout de ce fil alors que le signal monte dans le trou 22s devrait retourner vers l'autre bout 14 du fil 18d pour s'y écouler et causerait ainsi une réflexion parasite du signal. Selon les cas, cette perturbation peut être tolérée. Elle est ici réduite par la disposition des trous en quartets. De préférence aussi, les quartets seront disposés de façon complémentaire, comme illustré. Dans la figure 4, les potentiels se succèdent en alternance de façon complémentaire.

La figure 5 illustre une variante de disposition en quartets K des trous 22. Selon cette variante, les trous de signal 22s alternent sur une même ligne entre des trous de potentiel 22d et 22g communiquant avec les plans, les potentiels de ces trous étant aussi alternés. Les trous de potentiel 22D et 22G relatifs aux fils 18d et 18g sont placés en alternance sur une ligne parallèle. Chaque quartet est formé du triplet 22s, 22D, 22G et d'un trou 22d ou 22g, chaque trou de signal 22s étant avantageusement à proximité de deux trous 22d, 22g et de deux trous 22D, 22G. Cet agencement complémentaire minimise les effets parasites de la transmission des signaux à haute fréquence. Cette figure fait apparaître que d'autres dispositions peuvent être adoptées selon les cas.

On a vu que les triplets T forment avec les plans conducteurs 19d et 19g une structure approximativement coaxiale ayant une impédance caractéristique sensiblement constante et prédéterminée. On comprend que ces conditions devraient être continues entre les bornes 12 du circuit intégré et les bornes extérieures 15 du boîtier pour obtenir une transmission idéale de signaux à très haute fréquence. Cependant, la disposition des trous 22 dans le boîtier illustré conserve les triplets T mais elle peut conserver plus ou moins bien la structure coaxiale désirée. En d'autres termes, cette disposition peut ne plus conserver la valeur désirée de l'impédance caractéristique et créer ainsi une certaine désadaptation d'impédance. Cependant, il faut tenir compte des dimensions physiques et électriques relatives pour apprécier l'effet de cette désadaptation. En pratique, le boîtier 10 est un cadre typique de la technologie actuelle, de 40 mm de côté, dont la largeur, c'est-à-dire la distance entre ses côtés extérieurs et intérieurs, est de 12 mm et l'épaisseur totale est de 2,2 mm, faite de cinq couches isolantes ayant chacune une épaisseur t de l'ordre de 0,4 mm. Par conséquent, la longueur électrique maximale d'un trou 22 est d'environ deux millimètres et la désadaptation d'impédance qui en résulte ne devient sensible qu'à une fréquence de plus de 10 gigabits par seconde. Elle peut donc être tolérée dans les fréquences inférieures. Il en est de même pour les fils de liaison 16. On peut donc dire que la structure coaxiale s'étend de préférence le plus près possible des bornes extérieures 15 du boîtier et des bornes 12 du circuit intégré, de façon que la désadaptation d'impédance au niveau de ces bornes soit tolérable aux fréquences utilisées pour la transmission des données numériques en série.

Une façon d'obtenir une structure coaxiale conservant une impédance caractéristique presque continûment constante entre les bornes extérieures 15 du boîtier et les bornes 12 du circuit intégré pourrait consister par exemple à utiliser un boîtier du type TAB, dont les extrémités intérieures des conducteurs viendraient à l'aplomb des bornes du circuit intégré, les bornes 12 pouvant être périphériques comme illustré, ou être réparties sur la surface 11a. Les dimensions des trous pour la connexion intérieure et extérieure des conducteurs pourraient alors être très réduites. Ils pourraient bien sûr être aussi disposés pour conserver sensiblement la valeur désirée de l'impédance caractéristique. C'est le cas aussi des trous 22 dans le boîtier illustré, qui auraient pu être ainsi disposés mais qui ne l'ont pas été faute de place à cause de la section S2 qui sera décrite ultérieurement.

La figure 6 est une vue en coupe similaire à celle de la figure 2 et illustre une variante de réalisation de la structure coaxiale X. On notera de la figure 2 que la structure coaxiale X illustrée est tridimensionnelle, formée d'un triplet horizontal T au niveau N2 du cadre 13 et d'un triplet vertical formé par le fil de signal 18s et les deux plans 19d, 19g. Les triplets verticaux ne sont pas nécessairement des plans et peuvent être des fils. La figure 6 illustre une structure coaxiale X en croix, faite d'un fil de signal 18s placé au centre d'un carré dont les deux coins supérieurs sont formés de deux fils respectifs 18d, 18g et les deux coins inférieurs sont formés de deux autres fils 18d, 18g alternés de façon complémentaire. Dans la figure 6 également, les deux structures coaxiales X voisines partagent les deux mêmes fils de potentiel 18d, 18g placés entre les deux fils de signal 18s. Cette disposition verticale pourrait s'étendre de la même façon que la disposition horizontale des conducteurs 18. Par exemple, deux fils 18s placés à des niveaux différents seraient avantageusement séparés par deux fils de potentiels différents 18d et 18g. La figure 6 fait apparaître que d'autres structures coaxiales que celles illustrées peuvent donc être adoptées.

La figure 7 illustre encore une autre variante de réalisation. Le boîtier illustré à titre d'exemple a considéré que la transmission des signaux est unipolaire, faite suivant une ligne unifilaire 18s. Cependant, un boîtier conforme à l'invention peut être adapté à une transmission différentielle. La figure 7 est une vue semblable à celle de la partie supérieure de la figure 2 et suppose l'emploi d'une paire différentielle de signaux 18s, 18s*, sortant par exemple d'un amplificateur tampon différentiel (non illustré). Comme indiqué à la figure 7, la structure coaxiale X appliquée à la paire différentielle 18s, 18s* demeure la même que celle de la figure 2, à l'exception du fait qu'elle inclut la paire différentielle au lieu du conducteur unique 18s de la figure 2.

Le boîtier ayant la structure coaxiale qui vient d'être décrite avec un exemple relatif à l'informatique pour la transmission de données numérique en série peut bien sûr convenir à toute autre transmission se faisant aux très hautes fréquences.

On peut donc en conclure que l'invention a pour objet un procédé de liaison d'un circuit intégré 11 aux bornes extérieures 15 d'un boîtier 10 pour la transmission unipolaire ou différentielle d'au moins un signal, le boîtier comprenant des conducteurs d'au moins deux potentiels fixes et la transmission du signal se faisant suivant une structure tridimensionnelle approximativement coaxiale formée de deux paires de conducteurs des deux potentiels 18d, 18g ; 19d, 19g et ayant une impédance caractéristique sensiblement constante et prédéterminée.

La transmission unipolaire du signal se fait suivant un conducteur de signal 18s, tandis que la transmission différentielle du signal se fait suivant deux conducteurs de signal 18s, 18s*.

On a vu aussi que la structure coaxiale s'étend de préférence le plus près possible des bornes extérieures du boîtier et des bornes du circuit intégré. Il suffit que la désadaptation d'impédance qui en résulte soit tolérable aux fréquences utilisées.

L'invention a donc pour objet corollaire un boîtier 10 de circuit intégré 11, comprenant des conducteurs disposés sur au moins deux niveaux et répartis en conducteurs de signaux et en conducteurs d'au moins deux potentiels fixes, les deux paires de conducteurs des deux potentiels 18d, 18g ; 19d, 19g formant avec un ou deux conducteurs de signal 18s, 18s^{∗} une structure tridimensionnelle approximativement coaxiale ayant une impédance caractéristique sensiblement constante et prédéterminée .

On a vu que deux structures coaxiales voisines peuvent avoir au moins un conducteur de potentiel commun et que les conducteurs de potentiel de deux structures voisines ont de préférence des potentiels répartis de façon complémentaire.

Dans le boîtier décrit, une seule paire est faite de fils tandis que la variante de la figure 6 les deux paires sont faites de fils. Selon une autre variante, un seul conducteur des deux paires pourrait être plan. En résumé, au moins un conducteur des deux paires peut être plan, les autres étant des fils. Dans le boîtier illustré, une première paire est faite de conducteurs plans 19d, 19g et la seconde paire est faite de conducteurs filaires 18d, 18g disposés entre lesdits conducteurs plans sur un niveau intermédiaire, les conducteurs plans formant une paire commune aux structures coaxiales formées avec les conducteurs filaires intermédiaires. On a vu dans ce cas que les conducteurs filaires de deux structures voisines ont de préférence des potentiels différents.

Dans le boîtier illustré, les deux plans conducteurs se prolongent chacun par un rebord 21 servant à la connexion du plan correspondant à des bornes du circuit intégré et optionnellement à des bornes intérieures de conducteurs de potentiel. Cette disposition offre l'avantage de pouvoir connecter le rebord à n'importe quelle autre borne du boîtier ou du circuit intégré. Cependant, il est clair que cette disposition n'est pas nécessaire. Par exemple, une bande conductrice constituant le rebord 21 pourrait être reliée à un plan conducteur inférieur ou supérieur 19 par des trous conducteurs remplaçant l'extension latérale 20. Une telle bande pourrait aussi prolonger le plan sur le même niveau. Selon une autre variante, au moins l'un des plans pourrait se terminer par des bornes semblables aux bornes intérieures 14, placées sur le même niveau ou sur un niveau différent par l'intermédiaire de trous conducteurs.

Dans le boîtier illustré, le conducteur de signal et les conducteurs des deux paires ont chacun une extrémité connectée à une borne correspondante desdites bornes extérieures par l'intermédiaire d'un trou optionnellement partagé par celui relatif à une structure coaxiale voisine. Selon le type de boîtier utilisé, l'emploi de trous peut être évité. On a vu que ces trous pouvaient ou non former une structure ayant l'impédance caractéristique de la structure coaxiale X, et que des trous semblables pouvaient exister aux extrémités intérieures des conducteurs pour leur connexion aux bornes 12 du circuit intégré.

Enfin, on a vu aussi qu'une dissymétrie entre conducteurs de potentiel de l'une desdites paires peut être compensée de plusieurs façons, par exemple en adaptant l'épaisseur t et/ou la distance u entre conducteurs et/ou la constante diélectrique des couches isolantes.

Dans le boîtier illustré dans les figures 1 et 2, des bornes 12S, 12D et 12G sont intercalées entre les bornes d'entrée-sortie 12s, 12d et 12g du circuit intégré 11. Les bornes additionnelles de potentiel 12D et 12G servent à l'alimentation en énergie électrique du circuit intégré, comme les bornes 12d et 12g. La différence de notation sert à différencier les bornes 12d et 12g connectées aux conducteurs de potentiel 18d et 18g de chaque triplet de celles qui ne le sont pas. Les bornes 12D et 12G sont connectées aux plans conducteurs correspondants 19d et 19g par des fils de liaison 16 et, de préférence, à des fils libres 18D et 18G du niveau supérieur N4 par des fils de liaison 16', comme indiqué à la figure 2. De préférence également, les bornes 12D et 12G sont placées de façon complémentaire entre elles et/ou avec les bornes 12d et 12g. Les bornes de signal 12S illustrées dans les figures 1 et 2 sont destinées à la transmission de signaux de service, tels que par exemple les signaux de remise à zéro, d'initialisation et de maintenance du circuit électrique de la section S1 relative à la transmission de données numériques en série par l'intermédiaire des bornes 12s. Les signaux de service ne servent qu'occasionnellement et ont pratiquement toujours l'un des deux potentiels d'alimentation. Ces signaux sont donc aussi appelés "statiques". Cependant, ils ont une haute impédance et ne peuvent donc pas servir de fil de potentiel d'un triplet. La disposition des bornes 12S et des fils correspondants 16 et 18 évite de préférence leur interaction avec les signaux de transmission de données en série dans les bornes 12s et les fils correspondants 16 et 18s. Dans la figure 2, les bornes 12S sont ainsi placées en dehors des triplets ou entre deux triplets voisins. En outre, elles sont connectés à des fils 18S du niveau N4 de façon à être isolés des fils 18s par le plan conducteur 19d. Dans le niveau N4, les fils 18S sont aussi de préférence isolés entre eux par au moins un fil de potentiel 18D ou 18G pour éviter d'interagir entre eux. Dans l'exemple de la figure 2, ils sont aussi disposés en triplets, comme dans le niveau N2. Ce cas concerne donc un boîtier totalement destiné à la transmission de données à très haut débit.

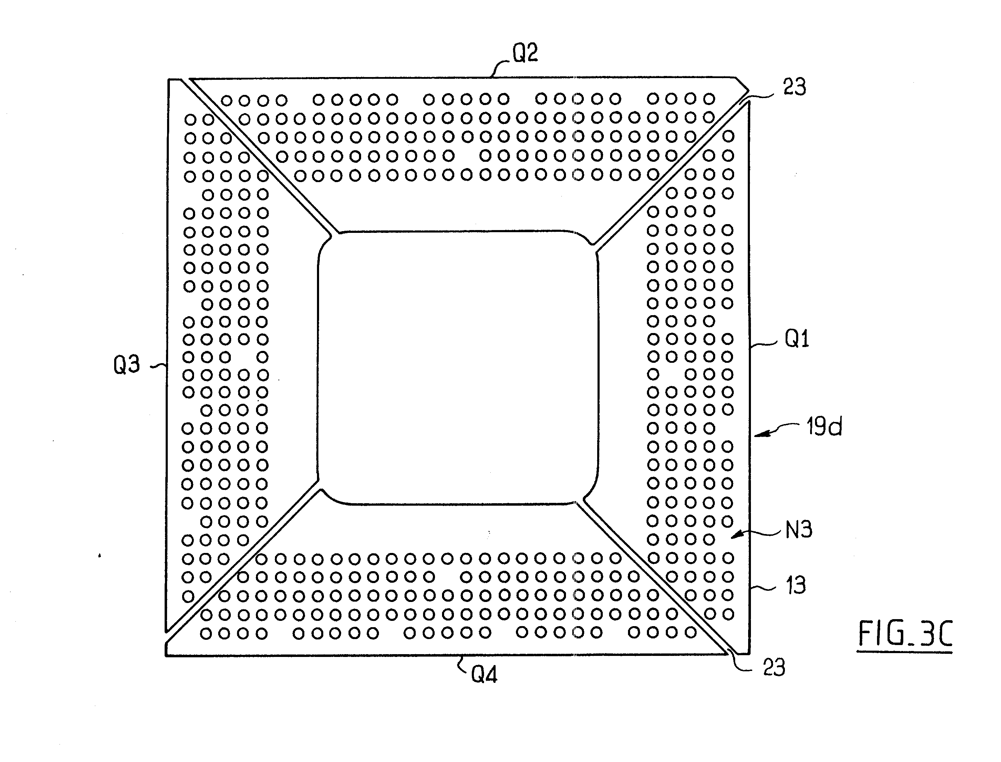

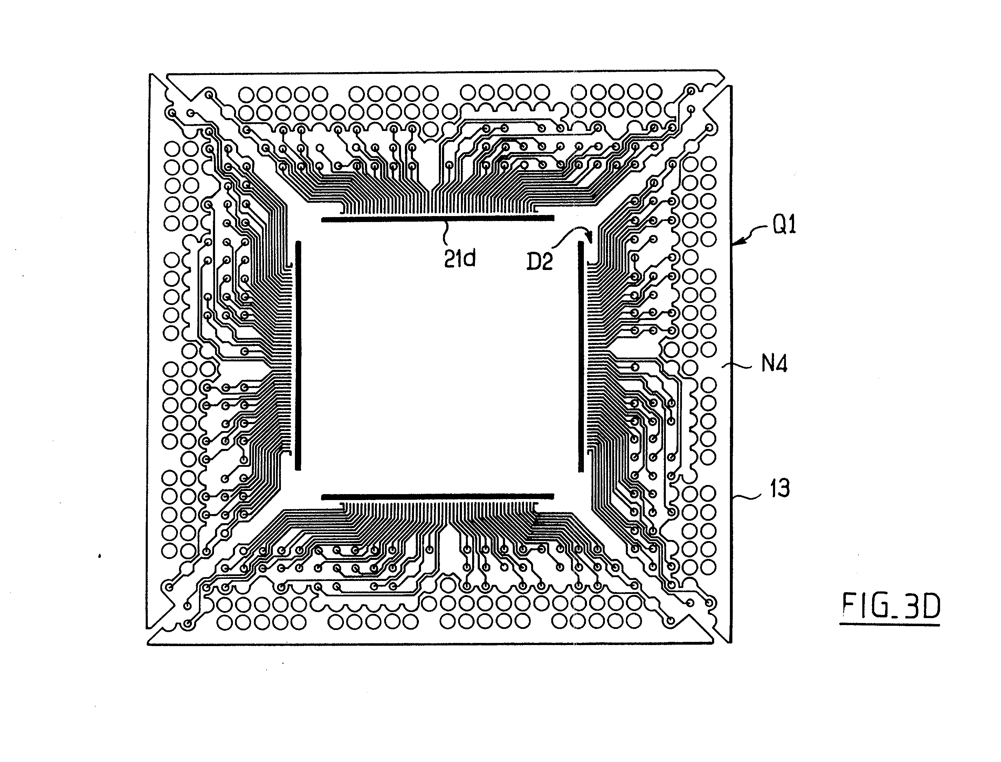

Les figures 3A, 3B, 3C et 3D sont respectivement des vues de dessus des niveaux N1, N2, N3 et N4 du cadre 13 et illustrent d'autres caractéristiques du boîtier 10. Les plans de potentiel 19g et 19d représentés sur les figures 3A et 3C sont divisés en quatre quartiers Q1-Q4 électriquement isolés entre eux, par exemple par des bandes isolantes 23 suivant les diagonales des plans conducteurs illustrés. Le quartier Q1 est destiné à la connexion de la section S1 pour la transmission des données en série tandis que les trois quartiers Q2-Q4 sont destinés à la connexion de la section S2 du circuit intégré 11. Ainsi, les grandes variations des potentiels des quartiers Q2-Q4 n'affectent pas le quartier Q1. Il est à noter que les trois quartiers Q2-Q4 pourraient ne pas être séparés par les bandes isolantes 23 et former un plan conducteur uniforme. Cependant, la division illustrée en quatre quartiers a l'avantage de laisser à chacun une fonction différente. Par exemple, deux quartiers pourraient servir à la section S1, un seul pour la section S2 et l'autre quartier pour une autre section traitant des signaux différents de ceux de S1 et S2. En outre, tous les plans illustrés sont divisés en quartiers et sont donc banalisés. On pourrait ainsi étendre la section S1 au plan 19'g, ou ne prendre que les plans 19d et 19'g pour la section S1.

II est à noter de la figure 3A que le quartier Q1 se prolonge par un anneau 24 entourant l'ouverture du cadre 13. L'anneau 24 sert à mettre à la masse la plaque 17 d'interface thermique du boîtier. Cependant, il est clair que l'anneau pourrait être connecté à au moins l'un des autres quartiers Q2-Q4 au lieu du quartier Q1. En variante, l'anneau pourrait être remplacé par une languette prolongeant au moins l'un des quartiers jusqu'au bord de l'ouverture pour être en contact avec la plaque 17, les autres quartiers restant à l'écart de la plaque. Cela permet de maintenir l'indépendance des quartiers.

D'autre part, les quatre quartiers illustrés Q1-Q4 sont connectés au voisinage de l'ouverture centrale du boîtier par l'intermédiaire de condensateurs de découplage respectifs C1-C4. Ces condensateurs sont donc adaptables à la fréquence de fonctionnement des quartiers respectifs et atténuent de façon optimale les variations de potentiel des plans 19 qu'ils contiennent. Par exemple, le condensateur C1 relatif au quartier Q1 pourra avoir une capacité de l'ordre du nanofarad, considérablement différente de celle des condensateurs C2-C4, qui peut être de l'ordre de 100 à 1000 nF.

La figure 3B a déjà été présentée et illustre le niveau N2 qui est de préférence utilisé pour la connexion de la section S1, à cause de la proximité du gradin D1 avec la section S1 et des faibles longueurs des fils de liaison 16 qui réduisent au mieux leurs composantes selfiques parasites. Les bornes 12s, 12d et 12g relatives à la section S1 du circuit intégré sont donc placées du côté du quartier Q1. Le niveau N2 illustré a ses quatre quartiers identiques et comprennent donc des fils 18 disposés en triplets pour former des structures coaxiales X avec les plans 19d et 19g. Cette disposition identique des quatre quartiers du niveau N2 offre l'avantage de pouvoir utiliser aussi bien l'un quelconque d'entre eux pour la transmission à très haute fréquence relative à la section S1, que plusieurs d'entre eux. Elle convient donc d'autant mieux à la section S2. Selon une variante de réalisation, l'ensemble des niveaux N1-N3 pourrait servir à la section S1 dont les bornes 12 seraient réparties sur toute la périphérie du circuit intégré. Les niveaux supérieurs serviraient alors pour la section S2. D'autre part, bien que les triplets illustrés T soient séparés entre eux et bien distincts les uns des autres, il est clair que tous les fils 18 pourraient être uniformément répartis dans chaque quartier. Les triplets pourraient alors être déterminés indépendamment de la disposition des fils 18.

D'une manière générale, au moins un plan conducteur peut être divisé en parties électriquement isolées. De préférence, deux plans conducteurs voisins auront leurs parties respectives en correspondance, non alternées. D'autre part, il est possible d'utiliser un ou plusieurs triplets dans au moins une des parties, ou tous les triplets du même niveau ou de niveaux différents.

Selon une autre variante, les triplets pourraient être très courts et connectés par l'intermédiaire de trous 22 à des bornes extérieures 15 très proches de l'ouverture centrale du cadre 13. Cependant, la disposition des bornes extérieures 15 de la section S1 à la périphérie extérieure du cadre 13 évite dans la carte de connexion PCB que des traversées correspondantes à haut débit se mêlent aux traversées relatives à la section S2. Il est ainsi possible de réduire l'interaction des signaux relatifs aux deux sections S1 et S2 dans la carte PCB. En outre, cette disposition assure une adaptation plus efficace de l'impédance de la carte PCB sur la valeur souhaitée. A ces avantages s'ajoute encore celui d'avoir dans la carte PCB des liaisons à haut débit très courtes entre les boîtiers que porte la carte PCB. Selon une autre variante, les triplets du niveau N2 pourraient être connectés à des trous respectifs 22 proches de l'ouverture du cadre, ces trous étant connectés à des triplets correspondants disposés sur le niveau N6 pour être connectés à des bornes extérieures 15 à la périphérie extérieure du cadre 13. Les triplets du niveau N6 seraient similaires à ceux représentés sur la figure 3B, à l'exception près qu'ils devraient serpenter entre les boules 15. Cette variante aurait donc comme inconvénient de ne pas offrir à chaque fil de signal sur le niveau N6 une structure coaxiale tridimensionnelle. Il en résulterait donc une interaction du signal avec d'autres passant par les boules 15 voisines et une plus grande difficulté d'adapter l'impédance caractéristique du triplet à la valeur désirée.

La figure 3B illustre aussi dans chaque quartier deux triplets médians dont les extrémités extérieures ne sont pas disposées à la périphérie du cadre comme les autres triplets T. Ces extrémités sont connectées à des trous respectifs 22 conduisant à une résistance étalon (non illustrée) qui sert de référence à une adaptation d'impédance, telle que décrite par exemple dans les documents du demandeur EP-A-0504061 (US-A-5402440), EP-A-0504062 (US-A-5398261), EP-A-0504063 (US-A-5347538) et EP-A-0639912.

Enfin, on a vu précédemment que le niveau N4 représenté sur la figure 3D sert, dans le quartier Q1 destiné à la section S1, à transmettre les signaux de service de cette section et à alimenter en énergie électrique le circuit intégré 11 tout en isolant les signaux de service entre eux. Dans les autres quartiers Q2-Q4, le niveau N4 est destiné à la section S2, comme d'ailleurs les quartiers Q2-Q4 du niveau N2 dans l'exemple illustré. Les conducteurs qui partent du gradin D2 ne nécessitent plus une disposition en triplets.

Puisque toutes les bornes extérieures 15 du boîtier 10 sont connectées aux fils 18 du cadre, un autre avantage du boîtier 10 est de pouvoir dorer par dépôt électrolytique les parties conductrices extérieures du cadre 13 en appliquant simplement un potentiel électrique sur ces bornes. La dorure des rebords 21 des plans 19 se fait en y appliquant également ce potentiel. Cela évite le procédé de dorure classique consistant à relier ces bornes à un bus métallique périphérique, à appliquer sur le bus un potentiel électrique et à déconnecter les bornes du bus après dorure. Outre les opérations additionnelles qu'il nécessite, ce procédé classique avait l'inconvénient de laisser des parties de fil de liaison attachées aux bornes et déconnectées du bus au voisinage de celui-ci. Ces parties de fil constituaient des antennes parasites aux fréquences utilisées.

Dans l'exemple illustré, le circuit intégré 11 a cent bornes d'alimentation en puissance 12d, 12g, 12D, 12G et trois cent vingt huit bornes de signal 12s, 12S. Les bornes 12D, 12G et 12S incluent aussi celles relatives à la section S2. Le boîtier a quatre cent quatre vingt bornes extérieures 15, dont cinquante-deux correspondent aux bornes d'alimentation 15d, 15g connectées aux plans de potentiel. Les trois cent vingt huit autres bornes sont affectées aux signaux et comprennent les bornes de signal 15s de transmission numérique en série de la section S1, les bornes 15S de transmission des signaux de service de la section S1 et les bornes 15S de transmission des signaux de la section S2. Les cent bornes extérieures 15 restantes sont de préférence les bornes 15D, 15G connectées aux fils de potentiel 18d, 18g des triplets T de la section S1. Le nombre supérieur au nombre minimal possible de ces bornes peut ainsi servir à diminuer la self des plans conducteurs 19, par exemple en connectant les bornes intérieures correspondantes 14 aux rebords 21 des plans conducteurs par l'intermédiaire de fils de liaison 16'. On peut ainsi favoriser la connexion à la masse ou à la tension selon l'application. Il en résulte une grande souplesse d'utilisation. Selon une autre variante possible, des fils 18d ou 18g, ou 18D, 18G peuvent servir à l'alimentation du circuit intégré en un autre potentiel que ceux relatifs aux plans 19d et 19g. Il suffirait de connecter leurs bornes intérieures respectives 14 aux bornes 12 correspondantes du circuit intégré, par l'intermédiaire de fils de liaison 16 dans l'exemple illustré. Par ailleurs, d'autres plans de potentiel 19 que ceux illustrés pourraient être ajoutés et reliés à des bornes extérieures correspondantes, notamment pour créer une capacité intégrée servant au découplage de l'alimentation.

## Revendications

1. Procédé de liaison d'un circuit intégré (11) aux bornes extérieures (15) d'un boîtier (10) pour la transmission unipolaire ou différentielle d'au moins un signal, le boîtier comprenant des conducteurs d'au moins deux potentiels fixes, caractérisé en ce que la transmission du signal se fait suivant une structure tridimensionnelle approximativement coaxiale formée de deux paires de conducteurs des deux potentiels (18d, 18g ; 19d, 19g) et ayant une impédance caractéristique sensiblement constante et prédéterminée.

2. Procédé selon la revendication 1, caractérisé en ce que la transmission du signal est unipolaire et se fait suivant un conducteur de signal (18s).

3. procédé selon la revendication 1, caractérisé en ce que la transmission du signal est différentielle et se fait suivant deux conducteurs de signal (18s, 18s∗).

4. Procédé selon la revendication 1, 2 ou 3, caractérisé en ce que la structure coaxiale s'étend le plus près possible des bornes extérieures du boîtier et des bornes (12) du circuit intégré.

5. Boîtier (10) de circuit intégré (11), comprenant des conducteurs disposés sur au moins deux niveaux et répartis en conducteurs de signaux et en conducteurs d'au moins deux potentiels fixes, caractérisé en ce que deux paires de conducteurs des deux potentiels (18d, 18g ; 19d, 19g) forment avec un ou deux conducteurs de signal (18s, 18s∗) une structure tridimensionnelle approximativement coaxiale ayant une impédance caractéristique sensiblement constante et prédéterminée.

6. Boîtier selon la revendication 5, caractérisé en ce que deux structures coaxiales voisines ont au moins un conducteur de potentiel commun (fig. 6).

7. Boîtier selon l'une des revendications 5 ou 6, caractérisé en ce que les conducteurs de potentiel de deux structures voisines ont des potentiels répartis de façon complémentaire (fig. 2).

8. Boîtier selon l'une des revendications 5 à 7, caractérisé en ce qu'au moins un conducteur des deux paires est plan (19d, 19g), les autres conducteurs étant filaires.

9. Boîtier selon l'une des revendications 5 à 8, caractérisé en ce qu'une première paire est faite de conducteurs plans (19d, 19g) et la seconde paire est faite de conducteurs filaires (18d, 18g) disposés entre lesdits conducteurs plans sur un niveau intermédiaire, les conducteurs plans formant une paire commune aux structures coaxiales formées avec les conducteurs filaires intermédiaires.

10. Boîtier selon la revendication 9, caractérisé en ce que les conducteurs filaires de deux structures voisines ont des potentiels différents (fig. 2).

11. Boîtier selon la revendication 8, 9 ou 10, caractérisé en ce qu'au moins l'un des plans conducteurs se prolongent par une bande (21) servant à la connexion du plan correspondant à des bornes du circuit intégré et optionnellement à des bornes intérieures de conducteurs de potentiel.

12. Boîtier selon l'une des revendications 5 à 11, caractérisé en ce que ledit conducteur (18s) ou les deux conducteurs de signal (18s, 18s∗) et les conducteurs des deux paires ont chacun une extrémité connectée à une borne correspondante desdites bornes extérieures par l'intermédiaire d'un trou optionnellement partagé par celui relatif à une structure coaxiale voisine.

13. Boîtier selon l'une des revendications 5 à 12, caractérisé en ce qu'une dissymétrie entre conducteurs de potentiel superposés de l'une desdites paires est compensée par une différence d'épaisseur et/ou de constante diélectrique des couches isolantes qui les séparent.

14. Boîtier selon l'une des revendications 5 à 13, caractérisé en ce que les conducteurs plans sont chacun divisés en au moins deux parties électriquement isolées.

15. Ensemble électronique; caractérisé en ce qu'il met en oeuvre le procédé défini par l'une des revendications 1 à 4 ou inclut au moins un boîtier tel que défini par l'une des revendications 5 à 14.
